(19) Europäisches Patentamt
European Patent Office
Office européen des brevets

(11) **EP 2 389 687 B1**

## (12) EUROPÄISCHE PATENTSCHRIFT

(45) Veröffentlichungstag und Bekanntmachung des Hinweises auf die Patenterteilung:
**17.04.2013 Patentblatt 2013/16**

(21) Anmeldenummer: **10700539.9**

(22) Anmeldetag: **12.01.2010**

(51) Int Cl.:
***H01L 27/16*** *(2006.01)*      ***H01L 35/32*** *(2006.01)*

(86) Internationale Anmeldenummer:
**PCT/EP2010/050302**

(87) Internationale Veröffentlichungsnummer:
**WO 2010/084059 (29.07.2010 Gazette 2010/30)**

(54) **THERMOELEKTRISCHES HALBLEITERBAUELEMENT**

THERMOELECTRIC SEMICONDUCTOR COMPONENT

ÉLÉMENT SEMICONDUCTEUR THERMOÉLECTRIQUE

(84) Benannte Vertragsstaaten:
**AT BE BG CH CY CZ DE DK EE ES FI FR GB GR HR HU IE IS IT LI LT LU LV MC MK MT NL NO PL PT RO SE SI SK SM TR**

(30) Priorität: **20.01.2009 DE 102009000333**

(43) Veröffentlichungstag der Anmeldung:
**30.11.2011 Patentblatt 2011/48**

(73) Patentinhaber: **IHP GmbH-Innovations for High Performance
Microelectronics / Leibniz-Institut für innovative Mikroelektronik
15236 Frankfurt / Oder (DE)**

(72) Erfinder:
• **KITTLER, Martin
15234 Frankfurt (Oder) (DE)**
• **REICHE, Manfred
06130 Halle (DE)**

(74) Vertreter: **Eisenführ, Speiser & Partner
Anna-Louisa-Karsch-Strasse 2
10178 Berlin (DE)**

(56) Entgegenhaltungen:
DE-A1- 4 306 497      DE-A1- 19 802 402
DE-A1-102006 047 071   DE-C1- 4 426 931
US-A1- 2006 102 223   US-A1- 2008 185 030

US-A1- 2008 230 105

• KITTLER M ET AL: "Dislocations as active components in novel silicon devices" ADVANCED ENGINEERING MATERIALS WILEY-VCH VERLAG GMBH GERMANY, Bd. 11, Nr. 4, April 2009 (2009-04), Seiten 249-258, XP002607446 ISSN: 1438-1656 DOI: DOI: 10.1002/ADEM.200800283
• BOUKAI A I ET AL: "Silicon nanowires as efficient thermoelectric materials" NATURE NATURE PUBLISHING GROUP UK, Bd. 451, Nr. 7175, 10. Januar 2008 (2008-01-10), Seiten 168-171, XP002607448 ISSN: 0028-0836 in der Anmeldung erwähnt
• KITTLER M ET AL: "Regular dislocation networks in silicon as a tool for nanostructure devices used in optics, biology, and electronics" SMALL WILEY-VCH VERLAG GMBH GERMANY, Bd. 3, Nr. 6, Juni 2007 (2007-06), Seiten 964-973, XP002607447 ISSN: 1613-6810 DOI: 10.1002/smll. 200600539
• YU X ET AL: "Properties of dislocation networks formed by Si wafer direct bonding" MATERIALS SCIENCE IN SEMICONDUCTOR PROCESSING, ELSEVIER SCIENCE PUBLISHERS B.V., BARKING, UK LNKD- DOI:10.1016/J.MSSP. 2006.01.070, Bd. 9, Nr. 1-3, 1. Februar 2006 (2006-02-01), Seiten 96-101, XP025175320 ISSN: 1369-8001 [gefunden am 2006-02-01]
• REICHE M: "Dislocation networks formed by silicon wafer direct bonding", MATERIALS SCIENCE FORUM TRANS TECH PUBLICATIONS LTD. SWITZERLAND, vol. 590, 2008, pages 57-78, ISSN: 0255-5476

EP 2 389 687 B1

**Beschreibung**

Die Erfindung betrifft ein thermoelektrisches Halbleiterbauelement und ein elektronisches Bauelement, das ein solches thermoelektrisches Halbleiterbauelement enthält.

Thermoelektrische Wandler bzw. Generatoren finden in vielen Gebieten der Technik Einsatz, wobei es vornehmlich darum geht, durch technisch notwendige Prozesse erzeugte Wärme nutzbar zu machen. Selbst bei der Herstellung von Halbleiter-Bauelementen ist ein Einsatz von thermoelektrischen Generatoren möglich. Die Ursachen für die Erzeugung von in elektrische Energie umzuwandelnder Wärme sind dabei vielfältig. So führt beispielsweise die elektrische Betriebsenergie von integrierten Schaltkreisen zu einer Erwärmung des gesamten Schaltkreises und kann bei herkömmlichen Mikrochips durchaus den Bereich von 70 - 80° C erreichen.

Diese Erwärmung ist in der Regel unerwünscht, so dass besondere Vorkehrungen in den Bauelementen getroffen werden müssen, um eine wärmebedingte Schädigung besonderer elektronischer Elemente zu verhindern. Einerseits kann die Wärme auf herkömmliche Art und Weise abgeführt werden, andererseits werden bereits im Vorfeld beim Schaltungsentwurf bestimmte Schichten, Schichtfolgen oder Materialien hinsichtlich ihrer Wärmeleitfähigkeit so entworfen und eingesetzt, dass eine ausreichende Abfuhr beim Betrieb entstehender Wärme gewährleistet ist. In Geräten wie Mobiltelefonen könnte die Nutzung der nicht unbeträchtlichen Wärme der darin eingesetzten Hochfrequenzbauteile zur Verlängerung der Benutzungsdauer innerhalb eines Batterieladezyklus führen. Im Falle von auftretenden Temperaturdifferenzen kann ein thermoelektrischer Generator in Niederverbrauchsgeräten sogar die herkömmliche Batterie ersetzen.

Daneben können derartige Wandler zur Kühlung eingesetzt werden. Dabei können herkömmliche Kühleinrichtungen unterstützt werden. Besonders vorteilhaft sind aber als Peltier-Kühler ausgebildete Wandler dort, wo auf Grund von Bauelementminiaturisierungen herkömmliche Methoden der Abfuhr von entstehender Betriebswärme nicht eingesetzt werden können.

Die Eignung von Halbleitermaterialien zum Einsatz in thermoelektrischen Halbleiterbauelementen wie Seebeck- oder Peltier-Elementen wird im Allgemeinen durch einen dimensionslose Gütezahl ZT beschrieben, die proportional zum Quadrat des Seebeck-Koeffizienten S sowie zur Temperatur und invers proportional zum spezifischem Widerstand p und der Wärmeleitfähigkeit κ ist. Die Gütezahl ZT ist wie folgt definiert:

$$ZT = S^2 \cdot T / \rho \cdot \kappa$$

Kommerziell weitreichend benutzte thermoelektrische Materialien wie zum Beispiel $Bi_2Te_3$ weisen eine Gütezahl ZT von ungefähr 1 auf, wohingegen Silizium als Volumenmaterial eine Gütezahl ZT von ungefähr 0,01 aufweist. Letzteres ist bedingt durch die große thermische Leitfähigkeit von Silizium, die einem Entstehen eines Temperaturgradienten in einem Siliziummaterialstück entgegenwirkt.

Kürzlich wurde gezeigt, dass bei einer Benutzung von Si-Nanodrähten (Siliziummaterialien mit Strukturgrößen im Nanometerbereich) ZT-Werte von 0,6 oder sogar 0,4 bei Raumtemperatur möglich sind, A. I. Boukai et al. "Si-Nanowires as efficient thermoelectric materials", Nature 451, 168 (2008); A. I. Hochbaum u.a. "Enhanced thermoelectric performance of rough Si nanowires", Nature Vol. 451, 163 (2008). Boukai u.a. nutzten dabei rechteckige Drähte mit Strukturgrößen im Bereich von 10 - 20 nm und Hochbaum u.a. nutzten Drähte im Größenbereich von 20 - 300 nm, welche raue Oberflächen und kreisförmige Querschnitte aufwiesen. Die beobachtete Erhöhung des ZT-Wertes für Silizium um beinahe zwei Größenordnungen, also von $10^{-2}$ bis zu Werten von ungefähr 1 wird hauptsächlich durch eine starke Verringerung der Wärmeleitfähigkeit innerhalb der Si-Nanodrähte zugeschrieben. Diese als "Phonon Drag" (engl., in etwa mit Phononenblockade zu übersetzen) bezeichnete Wirkung erweist sich al abhängig von Größe und Form der Nanodrähte und einen Wärmefluss einschränkenden Hindernissen wie etwa einer Oberflächenrauigkeit der Drähte.

Es wäre wünschenswert, diese Erkenntnisse in technisch nutzbare Vorrichtungen umzusetzen.

DE 198 02 402 A1 (SHIE JIN SHOWN [TW]) 18. Februar 1999 (1999-02-18) offenbart ein thermoelektrisches Halbleiterbauelement (Thermovoltaischer Generator), mit einer elektrisch isolierenden Substratoberfläche (S) und einer darauf angeordneten Vielzahl von einander beabstandeter, alternierend p-leitend (a) und n-leitend (b) ausgebildeter Halbleiterstrukturelemente (Dünnfilm-Thermoelemente), die in einer Reihenschaltung alternierend an zwei gegenüberliegenden Enden der jeweiligen Halbleiterstrukturelemente durch Leitstrukturen (Fig 5a) elektrisch leitend miteinander verbunden sind, derart, dass eine Temperaturdifferenz (h-c) zwischen den gegenüberliegenden Enden eine elektrische Spannung zwischen den Leitstrukturen erzeugt oder dass eine zwischen den Leitstrukturen bestehende Spannungsdifferenz eine Temperaturdifferenz zwischen den gegenüberliegenden Enden erzeugt.

Entsprechend liegt vorliegenden Erfindung das technische Problem zugrunde, ein thermoelektrisches Halbleiterbauelement anzugeben, das gegenüber thermoelektrischen Halbleiterbauelementen, deren Funktionsweise auf den Eigenschaften von Volumen-Halbleitermaterial beruht, verbesserte Eigenschaften aufweist.

Die Aufgabe wird gelöst durch ein thermoelektrisches Halbleiterbauelement mit einer elektrisch isolierenden Substratoberfläche und einer darauf angeordneten Vielzahl von einander beabstandeter, alternierend p-leitend und n-leitend ausgebildeter Halbleiter-strukturelemente, die in einer Reihenschaltung alternierend an zwei gegenüberliegenden Enden der jeweiligen Halbleiterstrukturelemente durch Leitstrukturen elektrisch leitend miteinander verbunden sind, derart, dass eine Temperaturdifferenz ($2\Delta T$) zwischen den gegenüberliegenden Enden eine elektrische Spannung zwischen den Leitstrukturen erzeugt oder dass eine zwischen den Leitstrukturen bestehende Spannungsdifferenz eine Temperaturdifferenz ($2\Delta T$) zwischen den gegenüberliegenden Enden erzeugt, dadurch gekennzeichnet, dass die Halbleiterstrukturelemente eine erste Grenzfläche zwischen einer ersten und einer zweiten Siliziumschicht aufweisen, deren als ideal gedachte Gitterstrukturen relativ zueinander um eine senkrecht zur Substratoberfläche stehende erste Achse um einen Drehwinkel verdreht und um eine zweite, parallel zur Substratoberfläche liegende Achse um einen Kippwinkel verkippt sind, derart, dass im Bereich der Grenzfläche ein Versetzungsnetzwerk vorliegt.

Das thermoelektrische Halbleiter-Bauelement der vorliegenden Erfindung entspringt der Erkenntnis, das die im Stand der Technik bekannt gewordenen Verbesserung Möglichkeiten des ZT-Wertes in Nanostrukturen für die Umsetzung in großtechnisch verwendbaren Halbleiter-Bauelementen mit einem Versetzungsnetzwerk besonders gut realisieren lassen. Es hat sich heraus gestellt, dass ein Versetzungsnetzwerk, wie es im erfindungsgemäßen thermoelektrischen Halbleiter-Bauelement vorgesehen ist, auf Grund von differiert einstellbaren Drehwinkeln und Kippwinkeln gezielt mit den gewünschten Eigenschaften herstellbar und besonderes gut reproduzierbar ist. Dies ist insbesondere für die industrielle Herstellung des thermoelektrischen Halbleiter-Bauelements von großer Bedeutung.

Weiterhin zeigt ein Versetzungsnetzwerk, wie es beim erfindungsgemäßen thermoelektrischen Halbleiter-Bauelement vorliegt ähnliche, zum Teil sogar deutlich verbesserte Charakteristika im Vergleich mit den von Boukai et al. verwendeten Nanodrähten. So kann in einem Halbleiter-Strukturelement, wie es in dem thermoelektrischen Halbleiter-Bauelement der Erfindung vorgesehen ist, der spezifische Widerstand p gegenüber einem aus Volumenmaterial gebildeten vergleichbaren Halbleiter-Strukturelement um etwa vier Größenordnungen verringert werden.

Auf diese Weise wird die Gütezahl ZT deutlich erhöht, was die thermoelektrische Eigenschaften des thermoelektrischen Halbleiter-Bauelements der vorliegenden Erfindung gegenüber herkömmlichen Bauelementen auf der Basis von Volumen-Halbleitermaterial deutlich verbessert.

Das thermoelektrische Halbleiter-Bauelement der vorliegenden Erfindung und seine nachfolgend beschriebenen Ausführungsbeispiele eignen sich besonderes zur Verwendung in elektronischen Halbleiter-Bauelementen, die zusätzlich mindesten einen integrierten Schaltkreis enthalten. Hierbei kann das thermoelektrische Halbleiterelement als thermoelektrische Generator oder auch als Wärmepumpe Anwendung finden. Durch eine monolithische Integration mit wärme erzeugenden elektronischen Schaltkreisen auf einem Chip, kann die erzeugte Wärme mit deutlich verbesserter Effizienz in nutzbare elektrische Energie umgewandelt werden.

Das thermoelektrische Halbleiter-Bauelement gemäß der vorliegenden Erfindung hat also den Vorteil, dass die durch den thermoelektrischen Generator gewonnene Energie zu einer Aufladung von Akkumulator-Zellen in dem Bauelement beziehungsweise mit dem Bauelement verbundenen solchen genutzt werden kann.

Nachfolgend werden Ausführungsbeispiele des thermoelektrischen Halbleiter-Bauelements der vorliegenden Erfindung beschrieben. Die zusätzlichen Merkmale der jeweiligen Ausführungsbeispiele können zur Bildung weiterer Ausführungsbeispiele mit einander kombiniert werden, wenn sie nicht einander ausschließende Alternativen bilden.

Bei dem thermoelektrischen Halbleiter-Bauelement ist die zweite Achse, die die Verkippung der ersten und zweiten Siliziumschicht zueinander definiert, vorzugsweise parallel oder annähernd parallel zu einer <110> - Richtung des Siliziumkristallgitters der Siliziumschichten orientiert. Die Anordnung des Versetzungsnetzwerks relativ zur Oberfläche der Halbleiterstrukturelemente hängt zum einem von der Dicke der Halbleiterstrukturelemente ab also von ihrer Erstreckung senkrecht zur Substratoberfläche. Zum anderen ist die Handhabbarkeit des Herstellungsprozesses des Versetzungsnetzwerks maßgeblich für die Anordnung des Versetzungsnetzwerks. In vorteilhaften Ausführungsformen liegt das Versetzungsnetzwerk in einer Tiefe von zwischen 20 nm und 1000 nm unterhalb einer von der Substratoberfläche abgewandten Oberfläche der Halbleiter-Strukturelemente. Je geringer die Dicke der Halbleiterstrukturelemente ist, desto größer ist der Einfluss des Versetzungsnetzwerks auf ihren spezifischen Widerstand. Daher ist eine Dicke im Bereich von vierzig bis einigen hundert Nanometern bevorzugt.

Ein weiterer Vorteil des thermoelektrischen Bauelements der vorliegenden Erfindung ist, dass die thermische Leitfähigkeit $\kappa$ gegenüber Volumenmaterial deutlich verringert werden kann. Dies wurde oben unter dem Stichwort "phonon drag" erläutert. Durch eine Dekoration des Versetzungsnetzwerks mit Präzipitaten werden zusätzliche Hindernisse für die Phonon Ausbreitung geschaffen, wodurch eine weitere Verringerung der thermischen Leitfähigkeit $\kappa$ erzielt wird. Der Vorteil dieses Ausführungsbeispiels liegt darin, das Präzipitate in kontrollierter Weise hergestellt werden können.

In ähnlich gut kontrollierbarer Weise sind bei den thermoelektrischen Halbleiter-Bauelement die geometrischen Parameter des Versetzungsnetzwerks einstellbar. Hierzu müssen bei der Herstellung des Halbleiterbauelements der Dreh- und der Kippwinkel kontrolliert werden. Dies ist beispielsweise mit dem Verfahren des Waferbondings, beispielsweise mit dem an sich bekannten SmartCut-Verfahren möglich. Vorzugsweise werden

dabei Winkel eingestellt, die ein Versetzungsnetzwerk mit Versetzungsstrukturen entstehen lassen, deren wechselseitige Laterallabstände im Bereich von ein bis fünfzig Nanometern liegt. Wichtig ist hierbei, das die Versetzungsstrukturen Ausmaße und Abstände aufweisen, die deutlich kleiner sind als die Strukturgröße der Halbleiter-Strukturelemente. Ein Ausführungsbeispiel hat beispielsweise einen Drehwinkel von 1,3° und einen Kippwinkel von 0,64°. Dabei sind die erste und zweite Siliziumschicht bevorzugt von zwei Siliziumscheiben mit (100) Oberflächen gebildet.

Hinsichtlich des Einflusses des Seebeck-Koeffizienten S führt die erfindungsgemäße Einbettung von Versetzungen und Versetzungsnetzwerken zu dessen Erhöhung. Diese führt aufgrund der quadratischen Abhängigkeit der dimensionslosen Gütezahl ZT vom Seebeck-Koeffizienten zu einer deutlich bemerkbaren Erhöhung dieser dimensionslosen, für die Wirksamkeit des thermoelektrischen Generators indiziellen Größe.

Nach heutiger Fertigungstechnik können der Drehwinkel und der Kippwinkel mit einer Genauigkeit von mindestens 0,1° hergestellt und bestimmt werden.

Grundsätzlich ist es auch denkbar, Siliziumscheiben mit anderer Oberflächen Orientierung als (100) zuwenden, etwa (111) oder (010) - orientierte Siliziumscheiben. Weitere Ausführungsbeispiel von Winkelkombinationen werden weiter unten im Zusammenhang mit der Beschreibung der Figuren angegeben.

Die Halbleiter-Strukturelemente können mit Hilfe an sich bekannter lithografischer Technologien mit einer großen Flächen bezogenen Anzahldichte hergestellt werden. Dies erlaubt in einer Reihenschaltung eine Erzeugung einer Spannung von einigen Volt bei einer Temperaturdifferenz von lediglich 10 K. Bevorzugt ist daher eine flächenbezogene Anzahldichte von mindestens 500 Halbleiter-Strukturelementen pro Quadratmillimeter. Besonders bevorzugt ist ein Wert von 1000 mm$^{-2}$ oder mehr.

Die Halbleiter-Strukturelemente auf der isolierenden Substrat Oberfläche haben im bevorzugten Ausführungsbeispielen Quaderformen, Stabformen oder Zylinderformen. Lithografisch besonders zuverlässig herstellbar sind stabförmige Halbleiter-Strukturelemente.

Ein thermoelektrisches Halbleiter-Element kann als Wandler-Bauelement erfindungsgemäß zur Umwandlung von Wärmeenergie in elektrische Energie derart ausgebildet sein, dass eine elektromotorische Kraft durch eine zwischen den Verbindungen der n-leitenden und p-leitenden Halbleiterelemente gebildete Temperaturdifferenz hervorgerufen wird und als Spannung an Kontakten der Reihenschaltung abgreifbar ist. Ein solches thermoelektrisches Wandler-Bauelement hat dann die Funktion eines Seebeck-Elements und entzieht elektronischen Bauelementen die in ihnen entstehende und diese belastende Wärme durch eine Umwandlung in elektrische Energie.

Das erfindungsgemäße thermoelektrische Halbleiter-Bauelement kann aber auch zur Umwandlung von elektrischer Energie in Wärmeenergie derart ausgebildet sein, dass eine an Kontakte der Reihenschaltung angelegte Spannungsdifferenz zu einer Temperaturdifferenz an Verbindungen der n-leitenden und p-leitenden Halbleiterelemente führt. Ein solches Peltier-Element kann dazu benutzt werden, elektronische Bauelemente zu kühlen (sogenannter Peltier-Kühler). Denkbar ist natürlich auch ein Einsatz als Wärmepumpe.

In einer Ausführungsform des erfindungsgemäßen thermoelektrischen Halbleiterbauelements bilden die Halbleiterstrukturelemente dünne Halbleiterschichten mit Schichtdicken im Nanometerbereich, im Nanometerbereich strukturierte Stäbe (Nanorods) und/oder Drähte (Nanowires). Diese sind in üblicher Strukturierungstechnik herstellbar.

Besonders bevorzugt ist das erfindungsgemäße thermoelektrischen Halbleiterbauelement in Siliziumtechnologie monolithisch integrierbar. Ein erfindungsgemäßes elektronisches Bauelement enthält daher ein thermoelektrisches Halbleiterbauelement nach einem der hierin beschriebenen Ausführungsbeispiele monolithisch integriert mit mindestens einem elektronischen Schaltkreis auf einem einzigen Substrat.

Bei einem elektronischen Bauelement, in dem das thermoelektrische Halbleiter-Bauelement monolithisch integriert ist, sind die Halbleiterstrukturelemente vorzugsweise auf der isolierenden Substratschicht eines SOI-Substrat (Silicon on Insulator) angeordnet. Der Vorteil liegt hierbei in einer problemlosen Hinzufügung beziehungsweise Verbindung mit in der umfangreichen Vielfalt der derzeitig in üblicher Siliziumtechnologie herstellbaren Bauelementen aller Art.

Alternativ oder ergänzend kann ein elektronisches Bauelement, das thermoelektrische Halbleiter-Bauelement auf einen ersten Chip enthalten und mindestens einen elektronischen Schaltkreis auf einem zweiten Chip, der mit dem thermoelektrischen Halbleiter-Bauelement thermisch oder elektrisch gekoppelt ist. Derartige Anordnungen als "Systemin-Package" bieten die Möglichkeit, eine verbesserte Kontrolle der Temperatur auch in dreidimensionalen Chipanordnungen zu gewährleisten.

Weitere vorteilhafte Ausgestaltungen ergeben sich aus den Unteransprüchen.

Die Erfindung wird nachfolgend anhand eines Ausführungsbeispiels mit den begleitenden Zeichnungen näher erläutert. Es zeigen:

Fig. 1 eine vereinfacht dargestellte Topologie eines erfindungsgemäßen Siliziumbauelements und

Fig. 2 einen auf einem Chip realisierten thermoelektrischen Wandler.

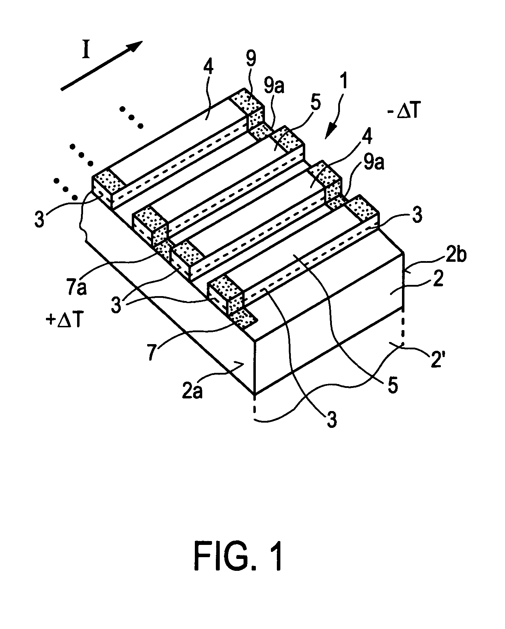

Figur 1 zeigt ein monolithisch integriertes thermoelektrisches Bauelement, das mit Hilfe eines Silizium-Waferbondings grundlegend hergestellt worden ist. Dazu ist ein oberer Siliziumwafer 1 auf einem SiO$_2$-Abschnitt eines unteren Wafers 2 durch Bonding aufgebracht worden. Eine gezielte Fehlpassung der Orientierungen eines mit einem Oxid-beschichteten, nur angedeuteten unteren Wafers 2 mit dem darauf aufgebrachten, gebondeten Wafer 1 hat zu einer Erzeugung von sehr stark schematisch durch gestrichelte Linien 3 gekennzeichneten Versetzungsnetzwerken geführt.

Der Wafer 1 ist durch in der Halbleitertechnologie an sich bekannte Prozessschritte, wie in der Lithographie üblich, typischerweise also Ionenbestrahlung, Ätzprozesse, Beschichtungstechniken, Maskenbelichtungsvorgänge, wie in der Figur 1 gezeigt strukturiert worden. Die Halbleiterelemente 4, 5 und die zwischen ihnen eingebrachten Gräben haben kürzeste Maße im Nanometerbereich.

Eine Abfolge von durch Einbringen von akzeptorartigen Dotierstoffen erzeugten p-leitenden Halbleiterelementen 4 mit durch ein Einbringen von donatorartigen Dotierstoffen erzielten n-dotierten Halbleiterelementen 5 bilden mit den jeweils zwischen ihnen liegenden, die Oberfläche des $SiO_2$-Abschnitts 2 freilegenden Gräben einen thermoelektrischen Wandler bzw. Generator. An einer ersten Stirnseite 2a des $SiO_2$-Abschnitts 2 sind die stabartigen p- und n-Halbleiterelemente 4, 5 mit Kontaktstreifen 7 versehen. Zu einer der ersten Seite 2a des $SiO_2$-Abschnitts 2 gegenüberliegenden zweiten Seite 2b sind die p- und n-Stäbe 4, 5 mit weiteren Kontaktelementen 9 versehen.

Sofern ein in der stark vereinfachten Figur 1 nicht gezeigtes, über die Einspeisung einer elektrischen Spannung und einen entsprechenden Stromfluss wärmeerzeugendes Bauelement an der Seite 2a vorhanden ist, wird zwischen den Kontaktelementen 7, 9 des thermoelektrischen Generators eine elektrische Spannung, die der zugeführten Wärme $+\Delta T$ entspricht, abgreifbar sein. Diese elektrische Spannung kann über entsprechende nicht gezeigte Leitungsanordnungen weiteren Verbrauchern oder Speicherelementen wie Akkumulatoren zugeführt werden. Die zweidimensional angeordneten n-leitenden und p-leitenden Halbleiterelemente sind alternierend in Reihe geschaltet. Dazu sind jeweils ein n- und ein p-Stab 4, 5 wechselseitig an den Seiten 2a und 2b mit Kontaktbrücken 7a beziehungsweise 9a verbunden. Ein Einsatz von einem n-leitenden und einem p-leitenden Halbleitermaterial als Thermopaar führt aufgrund des entgegengesetzten Vorzeichens ihrer absoluten, differenziellen Thermospannungen zu einer optimalen Ausnutzung des für die Erzeugung der Thermospannung verantwortlichen Temperaturgradienten $2\Delta T$.

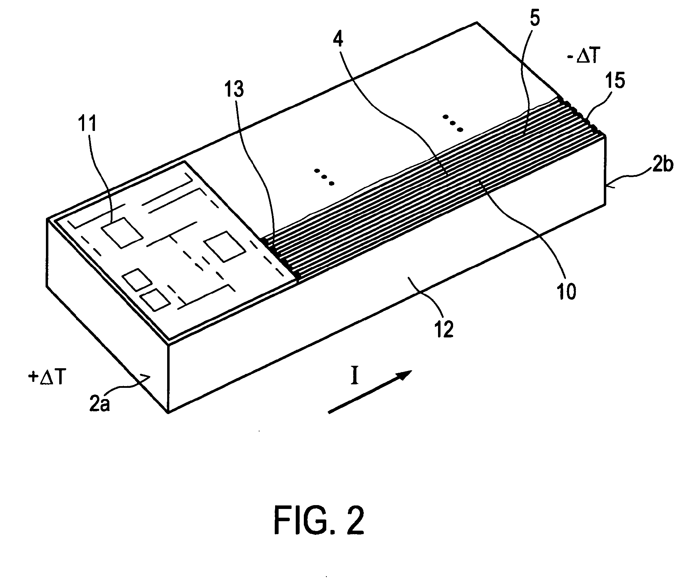

Gemäß Figur 2 ist ein thermoelektrischer Wandler 10 monolithisch integriert mit einem integrierten Schaltkreis 11 auf einem Halbleiterwafer 12 vorgesehen. Der Bereich 11 erzeugt im angeschlossenen Betriebszustand aufgrund der durch die in üblicher Halbleitertechnologie angebrachten miniaturisierten Schalt- und Speicherelemente Wärmeenergie. Diese ist hier stark vereinfacht durch den als Pfeil T dargestellten Temperaturgradienten zwischen den zwei sich um eine Temperatur $2\Delta T$ unterscheidenden Seiten 2a, 2b symbolisiert. Dadurch ist ein zwischen einer ersten Seite 12a und einer zweiten Seite 12b des Siliziumwafers entstehender Gradient von bis zu $2\Delta T=70°$ C vorhanden. Der sich an den integrierten Schaltkreis 11 anschließende thermoelektrische Generator der beispielsweise wie der in Figur 1 vereinfacht dargestellte thermoelektrische Generator ausgeführt sein kann, wandelt die ihm von dem integrierten Schaltkreis 11 zugeführte Wärme ($k_B \cdot 2\Delta T$) in eine zwischen Kontaktelementen 13 und 15 abnehmbare elektrische Thermospannung um. Diese kann bei einer Integration einer großen Zahl von Halbleiterelementen 4, 5 von größer als 1000 mm$^{-2}$ für eine herrschende Temperaturdifferenz $2\Delta T =10$ K durchaus einige Volt betragen. Der thermoelektrische Generator 10 weist in der Figur 2 nicht darstellbare Versetzungsnetzwerke auf, die in den im Nanobereich strukturierten stabartigen Halbleiterelementen 4, 5 eingebettet sind. Über das Einbringen der Versetzungsnetzwerke in den Nanostäben 4, 5 des thermoelektrischen Generators 10 wird eine Steigerung der von der Temperatur T abhängigen und den Größen Seebeck-Koeffizient S, Wärmeleitfähigkeit $\kappa$ und spezifischem Widerstand $\rho$ parametrisch abhängigen dimensionslosen Zahl ZT erreicht.

Erfindungsgemäß sind Versetzungen und/oder Versetzungsnetzwerke als bevorzugte Defekte im Kristallgitter der Halbleiterstrukturelemente vorgesehen. Denkbar ist aber auch ein zusätzlicher Einbau von Ausscheidungen, von Fremdatomen bzw. Fremdatomclustern. Ebenso können bei einer Verwendung von Verbindungshalbleitern durch wechselseitige Gitterfehlordnungsanordnungen hervorgerufene Antistrukturatome, sogenannte Antisite-Defekte als Kristalldefekte im Sinne der Erfindung benutzt werden. Ferner können als Defekte des Kristallgitters auch zwischen Bereichen unterschiedlicher kristallographischer Orientierung entstehende Korngrenzen vorgesehen sein. Entlang dieser vorhandene Ansammlungen von Fremdatomen können wie auch Fremdatom-Dekorationen an Versetzungen oder Versetzungsnetzwerken als Kristalldefekte im Sinne der Erfindung verstanden werden.

## Patentansprüche

1. Thermoelektrisches Halbleiterbauelement, mit einer elektrisch isolierenden Substratoberfläche und einer darauf angeordneten Vielzahl von einander beabstandeter, alternierend p-leitend (4) und n-leitend ausgebildeter Halbleiterstrukturelemente (5), die in einer Reihenschaltung alternierend an zwei gegenüberliegenden Enden der jeweiligen Halbleiterstrukturelemente durch Leitstrukturen elektrisch leitend miteinander verbunden sind, derart, dass eine Temperaturdifferenz (2$\Delta$T) zwischen den gegenüberliegenden Enden eine elektrische Spannung zwischen den Leitstrukturen erzeugt oder dass eine zwischen den Leitstrukturen (7, 9; 13, 15) bestehende Spannungsdifferenz eine Temperaturdifferenz (2$\Delta$T) zwi-

schen den gegenüberliegenden Enden erzeugt, **dadurch gekennzeichnet, dass** die Halbleiterstrukturelemente eine erste Grenzfläche zwischen einer ersten und einer zweiten Siliziumschicht aufweisen, deren als ideal gedachte Gitterstrukturen relativ zueinander um eine senkrecht zur Substratoberfläche stehende erste Achse um einen Drehwinkel verdreht und um eine zweite, parallel zur Substratoberfläche liegende Achse um einen Kippwinkel verkippt sind, derart, dass im Bereich der Grenzfläche ein Versetzungsnetzwerk vorliegt.

2.   Thermoelektrisches Halbleiterbauelement nach Anspruch 1 oder 2, bei dem die zweite Achse, die die Verkippung der ersten und zweiten Siliziumschicht zu einander definiert, parallel oder annähernd parallel zu einer <110>-Richtung des Siliziumkristallgitters orientiert ist.

3.   Thermoelektrisches Halbleiterbauelement nach einem der vorstehenden Ansprüche, bei dem das Versetzungsnetzwerk in einer Tiefe von zwischen 20 nm und 1000 nm unterhalb einer von der Substratoberfläche abgewandten Oberfläche der Halbleiterstrukturelemente angeordnet ist.

4.   Thermoelektrisches Halbleiterbauelement nach einem der vorstehenden Ansprüche, bei dem das Versetzungsnetzwerk mit Präzipitaten dekoriert ist.

5.   Thermoelektrisches Halbleiterbauelement nach einem der vorstehenden Ansprüche, bei dem das Versetzungsnetzwerk Versetzungsstrukturen mit wechselseitigen lateralen Abständen im Bereich von 1 bis 50 nm aufweist.

6.   Thermoelektrisches Halbleiterbauelement nach einem der vorstehenden Ansprüche, bei dem die Halbleiterstrukturelemente mit einer flächenbezogenen Anzahldichte von mindestens 500 pro Quadratmillimeter vorgesehen sind.

7.   Thermoelektrisches Halbleiterbauelement nach Anspruch 1, bei dem die Halbleiterstrukturelemente (4, 5) Quaderform, Stabform oder Zylinderform aufweisen.

8.   Elektronisches Bauelement, mit einem thermoelektrischen Halbleiterbauelement nach einem der vorstehenden Ansprüche 1 bis 6.

9.   Elektronisches Bauelement nach Anspruch 7, bei dem das thermoelektrische Halbleiterbauelement mit mindestens einem elektronischen Schaltkreis zusammen auf einem einzigen Substrat monolithisch integriert ist.

10.  Elektronisches Bauelement nach Anspruch 8, bei dem das Substrat, auf dessen elektrisch isolierender Substratoberfläche die Halbleiterstrukturelemente angeordnet sind, ein SOI-Substrat ist.

11.  Elektronisches Bauelement nach Anspruch 7, bei dem das thermoelektrische Halbleiterbauelement auf einem ersten Chip angeordnet ist und mit mindestens einem elektronischen Schaltkreis auf einem zweiten Chip thermisch oder elektrisch gekoppelt ist.

## Claims

1.   Thermoelectric semiconductor component, having an electrically insulating substrate surface and, arranged thereon, a plurality of semiconductor structural elements (5) of alternately p-conductive (4) and n-conductive configuration spaced apart from one another, which are connected in series to one another in electrically conductive manner by conductive structures at two opposite ends, alternately, of the respective semiconductor structural elements, such that a temperature difference $(2\Delta T)$ between the opposite ends produces an electric voltage between the conductive structures, or such that a voltage difference existing between the conductive structures (7, 9; 13, 15) produces a temperature difference $(2\Delta T)$ between the opposite ends, **characterised in that** the semiconductor structural elements comprise a first interface between a first and a second silicon layer, the lattice structures of which considered ideal, are rotated relative to one another through an angle of rotation about a first axis standing perpendicular to the substrate surface and have been tilted through a tilt angle about a second axis lying parallel to the substrate surface such that there is a dislocation network in the region of the interface.

2.   Thermoelectric semiconductor component according to claim 1 or 2, wherein the second axis, which defines the tilting of the first and second silicon layers to one another, is oriented parallel or approximately parallel to a <110>-direction of the silicon crystal lattice.

3.   Thermoelectric semiconductor component according to one of the preceding claims, wherein the dislocation network is arranged at a depth of between 20 nm and 1000 nm below a surface of the semiconductor structural elements remote from the substrate surface.

4.   Thermoelectric semiconductor component according to one of the preceding claims, wherein the dislocation network is decorated with precipitates.

5.   Thermoelectric semiconductor component according to one of the preceding claims, wherein the dislocation network comprises dislocation structures with alternating lateral spacings in the range from 1 to 50 nm.

6. Thermoelectric semiconductor component according to one of the preceding claims, wherein the semiconductor structural elements are provided in a number density per unit area of at least 500 per square millimetre.

7. Thermoelectric semiconductor component according to claim 1, wherein the semiconductor structural elements (4, 5) are cuboid, rod-shaped or cylindrical.

8. Electronic component having a thermoelectric semiconductor component according to one of the preceding claims 1 to 6.

9. Electronic component according to claim 7, wherein the thermoelectric semiconductor component is integrated together with at least one electronic circuit monolithically on a single substrate.

10. Electronic component according to claim 8, wherein the substrate on whose electrically insulating substrate surface the semiconductor structural elements are arranged is an SOI substrate.

11. Electronic component according to claim 7, wherein the thermoelectric semiconductor component is arranged on a first chip and is thermally or electrically coupled to at least one electronic circuit on a second chip.

**Revendications**

1. Elément semi-conducteur thermoélectrique, ayant une surface supérieure de substrat électriquement isolante et une pluralité d'éléments structurels semi-conducteurs (5), disposés sur ladite surface, écartés les uns des autres, formés en alternance avec une conduction de type P (4) et une conduction de type N, qui sont reliés entre eux de manière électroconductrice par des structures conductrices dans un montage série en alternance aux deux extrémités opposées des éléments structurels semi-conducteurs respectifs, de manière telle qu'une différence de température (2$\Delta$T) entre les extrémités opposées génère une tension électrique entre les structures conductrices ou qu'une différence de tension présente entre les structures conductrices (7, 9; 13, 15) génère une différence de température (2$\Delta$T) entre les extrémités opposées, **caractérisé en ce que** les éléments structurels semi-conducteurs présente une première surface limite entre une première et une deuxième couche de silicium dont des structures de grille considérées comme idéales sont tournées l'une par rapport à l'autre d'un angle de rotation autour d'un premier axe perpendiculaire à la surface supérieure du substrat et sont inclinées d'un angle d'inclinaison autour d'un deuxième axe parallèle à la surface supérieure du substrat de manière telle qu'un réseau de dislocation soit présent dans la zone de la surface limite.

2. Elément semi-conducteur thermoélectrique selon la revendication 1, dans lequel le deuxième axe, qui définit l'inclinaison des première et deuxième couches de silicium l'une par rapport à l'autre, présente une orientation parallèle ou pratiquement parallèle à une direction <110> du réseau cristallin de silicium.

3. Elément semi-conducteur thermoélectrique selon l'une quelconque des revendications précédentes, dans lequel le réseau de dislocation est disposé à une profondeur comprise entre 20 nm et 1000 nm en dessous d'une surface des éléments structurels semi-conducteurs qui est tournée vers la surface supérieure du substrat.

4. Elément semi-conducteur thermoélectrique selon l'une quelconque des revendications précédentes, dans lequel le réseau de dislocation est décoré avec des précipités.

5. Elément semi-conducteur thermoélectrique selon l'une quelconque des revendications précédentes, dans lequel le réseau de dislocation présente des structures de dislocation ayant des écarts latéraux alternés dans la plage de 1 à 50 nm.

6. Elément semi-conducteur thermoélectrique selon l'une quelconque des revendications précédentes, dans lequel les éléments structurels semi-conducteurs sont prévus avec une densité numérique surfacique d'au moins 500 par millimètre carré.

7. Elément semi-conducteur thermoélectrique selon la revendication 1, dans lequel les éléments structurels semi-conducteurs (4, 5) présentent une forme de parallélépipède, une forme de barre ou une forme de cylindre.

8. Composant électronique, doté d'un élément semi-conducteur thermoélectrique selon l'une quelconque des revendications précédentes 1 à 6.

9. Composant électronique selon la revendication 7, dans lequel l'élément semi-conducteur thermoélectrique est intégré de manière monolithique avec au moins un circuit électronique conjointement sur un seul substrat.

10. Composant électronique selon la revendication 8, dans lequel le substrat, sur la surface supérieure électriquement isolante duquel sont disposés les éléments structurels semi-conducteurs, est un substrat SOI.

11. Composant électronique selon la revendication 7, dans lequel l'élément semi-conducteur thermoélectrique est disposé sur une première puce et est couplé thermiquement ou électriquement avec au moins un circuit électronique sur une deuxième puce.

FIG. 1

FIG. 2

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 19802402 A1, SHIE JIN SHOWN

**In der Beschreibung aufgeführte Nicht-Patentliteratur**

- **A. I. BOUKAI et al.** Si-Nanowires as efficient thermoelectric materials. *Nature,* 2008, vol. 451, 168

- **A. I. HOCHBAUM.** Enhanced thermoelectric performance of rough Si nanowires. *Nature,* 2008, vol. 451, 163